(19) Europäisches Patentamt
European Patent Office
Office européen des brevets

(11) **EP 3 058 583 B1**

(12) **FASCICULE DE BREVET EUROPEEN**

(45) Date de publication et mention de la délivrance du brevet:
**04.11.2020 Bulletin 2020/45**

(51) Int Cl.:
**B82B 3/00** (2006.01)     **H01L 41/113** (2006.01)
**H01L 21/302** (2006.01)     **H01L 21/3105** (2006.01)

(21) Numéro de dépôt: **14784486.4**

(22) Date de dépôt: **16.10.2014**

(86) Numéro de dépôt international:
**PCT/EP2014/072263**

(87) Numéro de publication internationale:
**WO 2015/055786 (23.04.2015 Gazette 2015/16)**

(54) **PROCÉDÉ D'OBTENTION D'UNE COUCHE ONDULÉE LOCALEMENT SUSPENDUE SUR UN SUBSTRAT EXPLOITANT UNE DÉFORMATION PAR FORMATION DE RIDES**

VERFAHREN ZUR HERSTELLUNG EINER LOKAL AUF EINEM SUBSTRAT AUFGEHÄNGTEN GEWELLTEN SCHICHT UNTER VERWENDUNG EINER VERFORMUNG DURCH BILDUNG VON FALTEN

METHOD FOR OBTAINING A WAVY LAYER LOCALLY SUSPENDED ON A SUBSTRATE USING A DEFORMATION BY FORMATION OF WRINKLES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **17.10.2013 FR 1360110**

(43) Date de publication de la demande:
**24.08.2016 Bulletin 2016/34**

(73) Titulaire: **Commissariat à l'Énergie Atomique et aux Énergies Alternatives**
**75015 Paris (FR)**

(72) Inventeurs:
 • **BENAISSA, Lamine**
  **F-91300 Massy (FR)**
 • **MOULET, Jean-Sébastien**
  **F-73000 Chambery (FR)**

(74) Mandataire: **Brevalex**
 **95, rue d'Amsterdam**
 **75378 Paris Cedex 8 (FR)**

(56) Documents cités:
 • **"New ripple patterns observed in excimer-laser irradiated SiO2/polycrystalline silicon/SiO2 structures", APPLIED PHYSICS LETTERS, AMERICAN INSTITUTE OF PHYSICS, US, vol. 70, no. 26, 30 juin 1997 (1997-06-30) , page 3552, XP012018143, ISSN: 0003-6951, DOI: 10.1063/1.119230**
 • **E Epp ET AL: "Hollow Bragg waveguides fabricated by controlled buckling of Si/SiO 2 multilayers", Optics Express, 15 novembre 2010 (2010-11-15), pages 24917-24925, XP055157803, Extrait de l'Internet: URL:http://www.opticsinfobase.org/DirectPD FAccess/05B72800-D63A-7E87-17031D915F3BC AA D_208143/oe-18-24-24917.pdf?da=1&id=208143 &seq=0&mobile=no [extrait le 2014-12-10]**
 • **SERRANO JUSTIN R ET AL: "Micron-scale buckling of SiO2 on Si", JOURNAL OF APPLIED PHYSICS, AMERICAN INSTITUTE OF PHYSICS, US, vol. 92, no. 12, 15 décembre 2002 (2002-12-15), pages 7606-7610, XP012056834, ISSN: 0021-8979, DOI: 10.1063/1.1519337**
 • **LU Y F ET AL: "Controllable laser-induced periodic structures at silicon-dioxide/silicon interface by excimer laser irradiation", JOURNAL OF APPLIED PHYSICS AIP USA, vol. 80, no. 12, 15 décembre 1996 (1996-12-15), pages 7052-7056, XP002726614, ISSN: 0021-8979**

- YU J J ET AL: "Laser engineered rippling interfaces for developing microtextures, adherent coatings, and surface coupling", PROCEEDINGS OF THE SPIE - THE INTERNATIONAL SOCIETY FOR OPTICAL ENGINEERING SPIE-INT. SOC. OPT. ENG. USA, vol. 3898, 1999, pages 252-262, XP002726615, ISSN: 0277-786X

- JELLISON G E JR ET AL: "Time-resolved optical studies of oxide-encapsulated silicon during pulsed laser melting", JOURNAL OF MATERIALS RESEARCH USA, vol. 3, no. 3, mai 1988 (1988-05), pages 498-505, XP002726616, ISSN: 0884-2914

## Description

## DOMAINE TECHNIQUE

Le domaine de l'invention est celui de la fabrication de structures suspendues, et notamment de structures comprenant une couche ondulée qui repose localement sur un substrat en étant suspendue au-dessus du substrat en dehors de zones de contact adhérent localisé.

L'invention concerne plus précisément un procédé de fabrication de structures localement suspendues, ce procédé reposant sur la formation d'ondulations en surface d'un substrat, ces ondulations étant communément désignées par le terme de rides et étant caractérisées par une amplitude, une longueur d'onde et une orientation

## ÉTAT DE LA TECHNIQUE ANTÉRIEURE

Des structures localement suspendues au-dessus d'un substrat peuvent être déformées sous pression. De telles structures trouvent application dès lors qu'une déformation est nécessaire, par exemple pour réduire la résistance d'une zone de contact et en augmenter ainsi la fiabilité, ou encore lorsque la déformation d'une telle couche suspendue s'accompagne d'un phénomène physique tel par exemple qu'un effet piézoélectrique.

De telles structures sont généralement obtenues par lithographie. Or les approches non lithographiques basées sur des processus thermodynamique d'auto-organisation apparaissent particulièrement attractives compte tenu de leur potentiel économique et de leur compatibilité avec la production à grande échelle.

On connait de l'article « New ripple patterns observed in excimer-laser irradiated SiO2/polycrystalline silicon/SiO2 structures » de G.K. Giust et T.W. Sigmon (Appl. Phys. Lett. 70, 3552, 1997) une technique qui consiste à venir fusionner une couche de polysilicium recouverte d'une couche d'oxyde au moyen d'une irradiation laser, cette fusion résultant en la formation de rides.

## EXPOSÉ DE L'INVENTION

L'invention a pour objectif de proposer une technique peu complexe et aisément reproductible pour la fabrication d'une couche ondulée localement suspendue au-dessus d'un substrat.

Elle propose pour ce faire un procédé de formation d'une couche ondulée reposant localement sur un substrat à partir d'une structure comprenant une couche élastique contrainte sur une fondation à l'état solide présente en surface d'un substrat rigide. Le procédé comprend la mise en œuvre des étapes de :

- fusion de la fondation pour l'amener à l'état liquide pendant une durée supérieure ou égale à 50 ns, l'épaisseur de la fondation étant d'au moins 20 nm et inférieure à une épaisseur prédéterminée correspondant à une amplitude crête à crête théorique de rides, ladite fusion résultant en une relaxation de contrainte de la couche élastique qui engendre une déformation simultanée, par formation de rides, de la couche élastique et de la fondation, la formation des rides s'accompagnant d'un contact adhérent localisé entre la couche élastique et le substrat rigide dans des zones isolant des régions de la fondation ;
- solidification de la fondation pour la ramener à l'état solide, ladite solidification formant une structure solide présentant des rides en surface.

Le procédé est caractérisé en ce qu'il comporte en outre le retrait de la fondation ramenée à l'état solide pour suspendre une couche au-dessus du substrat en dehors des zones de contact adhérent localisé, la couche suspendue étant ondulée conformément aux rides en surface de la structure solide.

Certains aspects préférés mais non limitatifs de ce procédé sont les suivants :

- la fusion est réalisée au moyen d'un apport d'énergie sélectif selon lequel l'énergie est absorbée par la fondation plutôt que par la couche élastique contrainte avec un ratio de 100/1, de préférence avec un ratio de 1000/1 ;
- la durée de chacune des étapes de fusion et de solidification est inférieure à 1 seconde, de préférence inférieure à 1 microseconde ;
- une couche thermiquement isolante est intercalée entre la fondation et le substrat rigide ;
- la fondation étant conductrice électriquement et intercalée entre des matériaux électriquement isolant, la fusion de ladite au moins une partie de la fondation est réalisée par un apport d'énergie thermique exploitant l'effet joule ;
- la fondation étant intercalée entre des matériaux électriquement conducteurs et présentant une résistivité supérieure à celle desdits matériaux électriquement conducteurs, la fusion de ladite au moins une partie de la fondation est réalisée par un apport d'énergie thermique exploitant un échauffement résistif ;
- les étapes de fusion et de solidification sont réitérées avant l'étape de retrait de la fondation ramenée à l'état solide, de manière à augmenter l'amplitude des rides et l'intervalle entre les régions isolées de la fondation sans atteindre la limite de rupture de la couche élastique ;
- le retrait de la fondation ramenée à l'état solide est réalisé par gravure sélective de la fondation vis-à-vis du substrat rigide et vis-à-vis d'une couche ondulée reposant sur la fondation et localement sur le substrat rigide ;
- la couche suspendue est formée par la couche élastique ;
- il comprend avant retrait de la fondation, une étape de retrait de la couche élastique suivie d'une étape de dépôt d'une nouvelle couche en surface du substrat et de la fondation, ladite nouvelle couche formant la couche suspendue après retrait de la fondation ;

- la couche élastique dispose initialement d'une contrainte présentant une rupture de continuité dans le plan de la couche ;
- il comprend une étape de création de motifs en surface de la couche élastique et/ou de la fondation pour induire ladite rupture de continuité.

**BRÈVE DESCRIPTION DES DESSINS**

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

- les figures la-lc illustrent la structuration de surface par formation de rides ;
- les figures 2a-2d illustrent un exemple de procédé de formation de rides ;
- la figure 3 représente les rides formées en surface d'un substrat selon l'exemple de procédé de formation de rides des figures 2a-2d ;
- les figures 4a-4c illustrent un cycle fusion/solidification pouvant être mis en œuvre dans le procédé selon l'invention ;
- les figures 5a-5b illustrent la création d'un bas-relief pour orienter les rides formées en surface d'un substrat dans une mise en œuvre du procédé selon l'invention ;
- les figures 6a-6e illustrent une variante de réalisation du second mode de réalisation possible du procédé selon l'invention exploitant une fondation en un matériau qui se contracte à l'état liquide ;
- la figure 7 représente les rides formées en surface d'un substrat selon le nombre de réitérations des étapes de fusion et de solidification pouvant être mis en œuvre dans le cadre de l'invention.

**EXPOSÉ DÉTAILLÉ DE MODES DE RÉALISATION PARTICULIERS**

L'invention repose sur l'idée originale d'utiliser un procédé de structuration de surface pour conduire à la formation d'une couche ondulée localement suspendue au-dessus d'un substrat.

La structuration de surface trouve application dans de nombreux domaines, tels que dans le domaine de l'électronique où elle permet notamment la miniaturisation des composants, ou encore dans le domaine de l'optique où elle permet par exemple d'améliorer l'efficacité de la collection de lumière de cellules photovoltaïques.

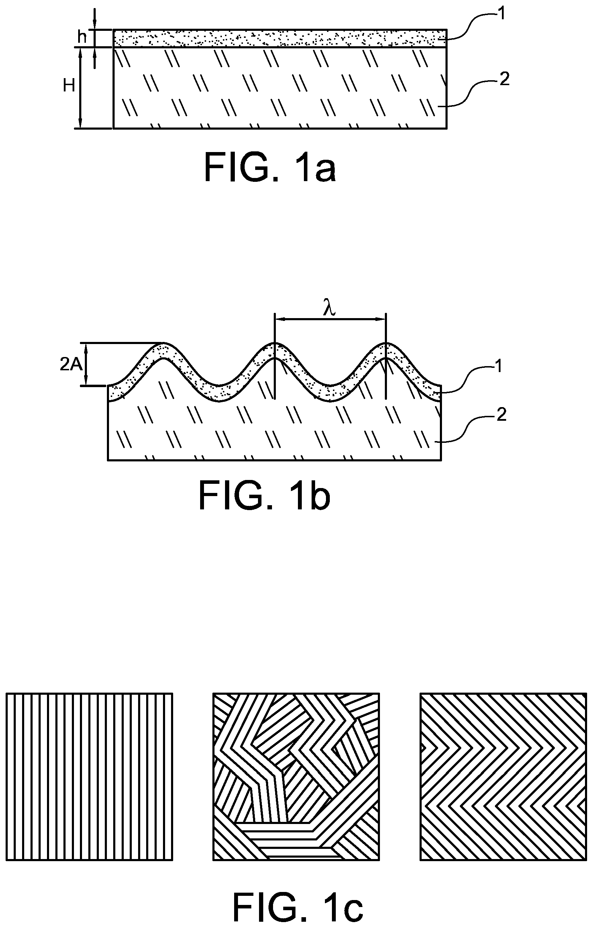

La structuration de surface peut suivre une approche non lithographique basée sur des processus thermodynamiques d'auto-organisation. Un exemple d'une telle approche, illustrée par les figures la-lc, repose sur la déformation d'une couche mince élastique 1 d'épaisseur h attachée à un support plus épais 2, d'épaisseur H, désigné par la suite par le terme de fondation. Cette déformation a pour moteur une contrainte qui relativement à la couche élastique correspond à un effort de compression de la fondation sur la couche. Cette contrainte introduit une instabilité du système couche élastique/fondation et conduit à la formation de rides caractérisées, comme représenté sur la figure 1b, par leur longueur d'onde λ et leur amplitude A (correspondant à la moitié de la hauteur crête à crête 2A). Comme représenté sur la figure le, les rides sont également caractérisées par leur orientation O qui peut prendre la forme de bandes (à gauche), de labyrinthes (au centre) ou de chevrons (à droite).

La théorie des rides décrit deux modes suivant lesquels le système couche élastique/fondation va gérer cette instabilité.

Lorsqu'à la fois la couche mince 1 et la fondation 2 sont élastiques, le système évolue spontanément pour minimiser son énergie. Dans ce contexte, l'émergence de rides d'une longueur d'onde donnée correspond à un compromis entre l'énergie de flexion du système et l'énergie nécessaire pour déformer la surface de la fondation. La formation des rides est au premier ordre dictée par le rapport des modules élastiques entre la peau et la fondation, leur rapport en épaisseurs et l'intensité de la contrainte à relaxer par le système. Plus la raideur de la fondation est faible, plus la contrainte critique nécessaire à la formation des rides est faible.

Sur le plan pratique, il faut donc des matériaux aux propriétés exceptionnelles (élastique et raideur faible) tels que les élastomères pour observer des rides. Une couche mince fortement contrainte sur une fondation rigide aura en effet tendance à produire une flèche plutôt que des rides.

Il est par ailleurs à noter qu'une fois les rides formées, le système est à l'équilibre. Le retrait de la couche mince provoque dès lors un retour spontané de la fondation élastique à son état initial, à savoir sans rides.

Lorsque la fondation est visqueuse, la formation des rides est provoquée pour des contraintes beaucoup plus faibles et l'énergie du système est principalement dissipée par écoulement visqueux de la fondation. Contrairement au système élastique/élastique, l'amplitude des rides est dans ce cas de figure assujettie à une cinétique qui est gouvernée par le module de relaxation de la fondation visqueuse. L'amplitude des rides est de ce fait limitée, et en pratique incompatible avec les applications visées.

Sur le plan pratique, la compréhension du système élastique/visqueux a permis l'élaboration de stratégies permettant la suppression des rides de faible amplitude. Par exemple en transférant des films contraints sur des fondations ad hoc, il est possible d'inverser le processus de formation des rides. Cela permet par exemple pour des films monocristallins d'autoriser une relaxation par expansion latérale plutôt que par la formation de dislocations.

Il existe pour ce deuxième mode un cas particulier qui correspond à la condition limite d'une fondation liquide. Un film mince contraint déposé sur un liquide forme en effet systématiquement des rides en surface compte tenu du faible module de relaxation du liquide. La manipulation d'un tel système (couche mince sur liquide) est toutefois sensible, ce qui limite à ce jour les applications aux études en laboratoire et/ou à la caractérisation de films minces.

Pour ces différents modes de relaxation, ils existent des solutions analytiques ou semi-analytiques qui permettent de décrire précisément la longueur d'onde et l'amplitude des rides formées. En ce qui concerne l'orientation, de nombreuses études rapportent que des ruptures de contrainte dans le plan sont à l'origine d'orientations privilégiées. Ainsi la création d'un bas-relief et ou bien la définition de motifs permettent d'orienter précisément les rides suivant la distribution du champ de contrainte dans le plan.

Il ressort de ce qui précède que les procédés de structuration de surface par formation de rides sont aujourd'hui essentiellement cantonnés à certains types de polymères, alors que pour les autres matériaux, la faible amplitude des rides obtenues (typiquement de l'ordre de 10 nm, soit inférieure à 20 nm crête à crête) reste incompatible avec les applications visées ou complexe à mettre en œuvre pour une production à grande échelle.

Il est proposé dans le cadre de l'invention d'avoir recours à un procédé de formation de rides qui permet d'étendre la structuration de surface par formation de rides à d'autres matériaux que les polymères, tels que des métaux, des semi-conducteurs, des oxydes, de manière aisément reproductible et avec une amplitude de structuration facilement exploitable, c'est-à-dire supérieure à 30 nm (soit 60 nm crête à crête) et plus typiquement une amplitude supérieure à 100 nm (soit supérieure à 200 nm crête à crête),

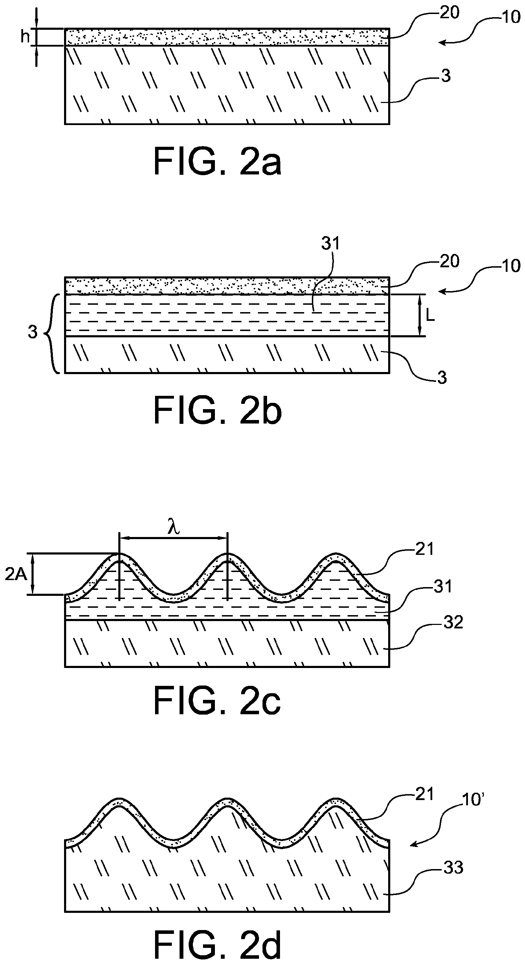

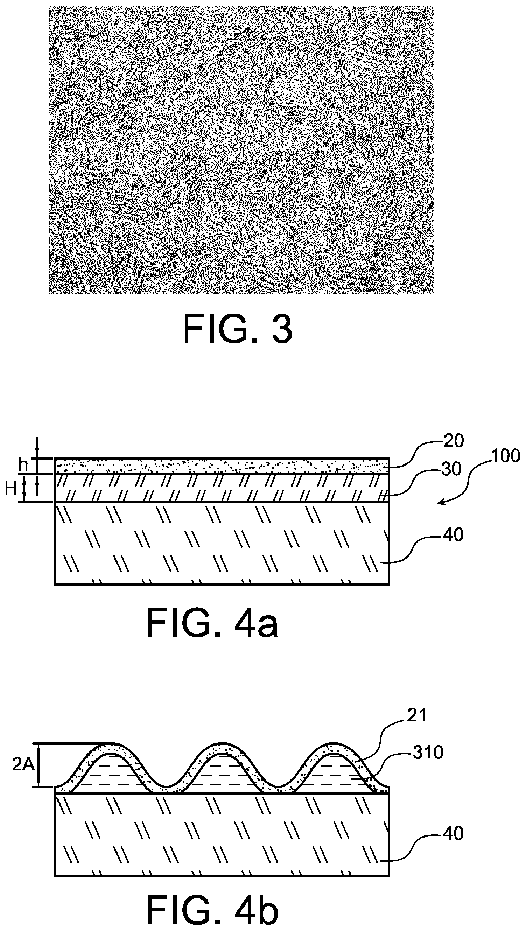

En référence à la figure 2a (ne faisant pas partie de l'invention) et à la figure 4a (qui illustre l'invention), l'invention repose sur un procédé de structuration de surface d'une structure bicouche 10, 100 comprenant initialement une couche contrainte 20 sur une fondation à l'état solide 3, 30. La couche contrainte 20 est plus particulièrement une couche élastique d'épaisseur h tandis que la fondation peut prendre la forme d'un substrat 3 comme représenté sur la figure 2a, ou d'une couche 30 d'épaisseur H formée en surface d'un substrat rigide 40 comme représenté sur la figure 4a.

La couche mince élastique contrainte 20 présente plus particulièrement une contrainte en tension dans au moins une direction du plan de la couche mince, ou bien une contrainte en compression uniquement dans une direction du plan.

La couche mince élastique 20 peut être formée par mise en œuvre d'un dépôt sur la fondation 3, 30, ou encore être formée par mise en œuvre d'une réaction chimique à la surface de la fondation (par exemple une oxydation, nitruration, carburation, etc.). La contrainte de la couche mince élastique est liée notamment au désaccord entre les paramètres de mailles des matériaux constituant la fondation et la couche mince, et peut être ajustée en jouant sur les conditions de formation de la couche mince, par exemple via la température du dépôt qui engendre une contrainte thermique plus ou moins importante selon la différence entre les coefficients de dilatation thermique de la couche mince et de la fondation.

En référence à la figure 2b (ne faisant pas partie de l'invention) et à la figure 4b (qui illustre l'invention), le procédé selon l'invention comprend une étape de fusion d'une partie au moins de la fondation pour l'amener à l'état liquide, ladite partie au moins étant au contact de la couche élastique contrainte.

Ladite partie au moins de la fondation amenée à l'état liquide présente une épaisseur L, et peut correspondre dans un exemple illustratif à une couche supérieure 30 d'une fondation sous la forme d'un substrat 3 au contact de la couche mince élastique (figure 2b) ou encore dans le cadre de l'invention à l'intégralité d'une fondation sous la forme d'une couche 30 d'épaisseur H en surface d'un substrat rigide 40 (figure 4b).

Comme illustré sur la figure 2c (ne faisant pas partie de l'invention) et sur la figure 4b (qui illustre l'invention), ladite partie au moins désormais liquide 31, 310 découple mécaniquement la couche mince élastique contrainte 20 d'une partie solide constituée par la partie solide 32, non fusionnée, du substrat-fondation 3, ou encore constituée par le substrat rigide 40 sous la couche-fondation 30. Durant le temps de fusion, la structure bicouche 10, 100 se positionne dans la condition limite correspondant à une relaxation théorique couche mince élastique / fondation visqueuse avec un temps de relaxation infini. La relaxation de la contrainte de la couche élastique engendre une déformation simultanée de la couche élastique et de ladite partie au moins liquide de la fondation. Le caractère liquide autorise et favorise la formation de rides plutôt qu'une déformation en flexion. Pour obtenir une structuration d'amplitude supérieure à 30 nm, il est nécessaire que l'épaisseur L rendue liquide soit supérieure ou égale à 20 nm, avantageusement supérieure ou égale à 30 nm, et que la durée pendant laquelle cette couche est liquide soit d'au moins 50 ns pour permettre une relaxation maximale de la couche mince 20. Plus l'épaisseur L de la fondation rendue liquide est importante, plus l'amplitude des rides recherchées peut croître. Il existe toutefois une valeur maximale Lmax de l'épaisseur rendue liquide au-delà de laquelle l'amplitude des rides ne peut plus croitre, cette amplitude maximale étant dictée par la théorie des rides dans le régime de croissance homogène et linéaire de l'amplitude. A titre d'exemple illustratif, on choisit, pour une amplitude de ride recherchée supérieure à 75nm, une épaisseur L typiquement de l'ordre de 50 à 100 nm.

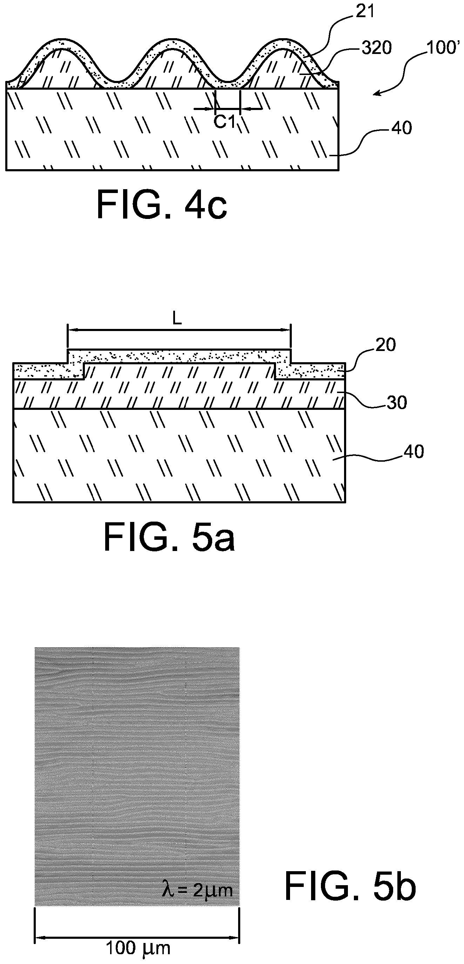

Comme illustré par la figure 2d (ne faisant pas partie de l'invention) et par la figure 4c (qui illustre l'invention), le procédé comprend ensuite une solidification de ladite partie au moins 21, 310 de la fondation pour la ramener à l'état solide, ladite solidification formant une structure solide 10', 100' présentant des rides en surface. Ce retour aux conditions initiales (état solide de la fondation) permet de figer les rides formées.

L'étape de fusion peut être plus particulièrement réalisée par un apport d'énergie sélectif de manière à ce que l'énergie soit majoritairement absorbée par ladite partie au moins de la fondation d'épaisseur L plutôt que par la couche élastique contrainte et que par le substrat rigide sous-jacent 40 le cas échéant, par exemple avec un ratio d'au moins 100/1, de préférence avec un ratio d'au moins 1000/1.

La couche mince présente de préférence une température de fusion supérieure à la température de fusion de la fondation. De la même manière, le substrat rigide 40 soutenant dans le second mode de réalisation une couche-fondation 30 présente également de préférence une température de fusion supérieure à la température de fusion de la fondation. Alternativement, ou en complément, une couche intermédiaire thermiquement isolante peut être intercalée entre la couche-fondation 30 et le substrat rigide 40 de manière à isoler le substrat rigide 30 des phénomènes thermiques. Ici encore, la couche intermédiaire thermiquement isolante présente de préférence une température de fusion supérieure à la température de fusion de la fondation.

La fondation peut présenter une combinaison de deux matériaux ou plus, de manière à en réduire la température de fusion ou encore d'en améliorer l'absorption de l'apport d'énergie. A titre d'exemple illustratif, un dopage du silicium permet d'en abaisser la température de fusion.

La couche mince peut également présenter une combinaison de deux matériaux ou plus. La combinaison des matériaux peut présenter des propriétés physiques moyennes équivalentes (module d'Young, Poisson, et contrainte) permettant d'ajuster au mieux la structure visée d'après la théorie des rides et/ou peut présenter un comportement moyen vis-à-vis de la source d'énergie de telle sorte que le ratio d'absorption de l'énergie soit au moins de 1/100 idéalement 1/1000 vis-à-vis de la fondation.

La durée de l'étape de fusion est typiquement comprise entre 50ns et 1s, avantageusement entre 50ns et 1ms. On privilégie des durées courtes pour éviter d'élever en température toute la fondation et de trop affecter les propriétés mécaniques de la couche mince. Pour des configurations équivalentes, l'épaisseur de la fondation rendue liquide et la durée à l'état liquide sont les deux paramètres principaux permettant d'ajuster l'amplitude des rides.

La durée de l'étape de refroidissement est également avantageusement contrôlée pour rester inférieure à 1s, avantageusement inférieure à 1ms, et ce afin de préserver les rides pendant le refroidissement. Cette durée peut en particulier être adaptée à la période des rides recherchée. En effet, plus la durée de refroidissement est importante, plus la longueur d'onde des rides est élevée. On peut ainsi freiner le refroidissement, par exemple par un ou plusieurs apports d'énergie pendant cette période, en fonction de la période recherchée.

Suivant la nature des matériaux en jeu, la fusion peut être obtenue en en ayant recours à une source d'énergie laser à une longueur d'onde choisie pour assurer une sélectivité de l'apport d'énergie suivant l'épaisseur et l'absorption des matériaux en jeu, ou encore en ayant recours à une source magnétique d'induction ou une source micro-onde. A titre d'exemple illustratif, on peut utiliser une source laser émettant dans l'ultraviolet, par exemple à une longueur d'onde autour de 300 nm, lorsque la couche mince, par exemple en $SiO_2$, est transparente aux ultra-violets et que la fondation absorbe au contraire cette lumière, par exemple lorsqu'elle constituée de silicium.

Lorsque la fondation est conductrice électriquement (c'est le cas notamment lorsqu'elle est métallique, par exemple en cuivre) et intercalée entre des matériaux électriquement isolant (couche mince d'un côté, couche intermédiaire et/ou substrat rigide 40 de l'autre), la fusion de ladite au moins une partie de la fondation peut être réalisée par un apport d'énergie thermique exploitant l'effet joule. Lorsque la fondation est intercalée entre des matériaux électriquement conducteurs (couche mince d'un côté, couche intermédiaire et/ou substrat rigide 40 de l'autre) et présente une résistivité supérieure à celle desdits matériaux électriquement conducteurs, la fusion de ladite au moins une partie de la fondation peut être réalisée par un apport d'énergie thermique exploitant un échauffement résistif.

La quantité d'énergie nécessaire pour réaliser la fusion de tout ou partie de la fondation peut être prédéterminée en venant détecter le changement de phase de tout ou partie de la fondation d'une structure étalon, par exemple au moyen d'une mesure de réflectivité, de résistivité, de densité, etc.

Les rides créées sont caractérisées par leur longueur d'onde λ, leur amplitude A et leur orientation O suivant la théorie des rides, et sont principalement liées aux paramètres physiques de la couche mince et de la fondation dans sa phase liquide.

On considère à titre d'exemple illustratif une couche mince en $SiO_2$ (peau) d'une épaisseur h de 50 nm avec une contrainte en tension de 200 MPa. La fondation est en Si amorphe et fusionnée sur une épaisseur L de 150 nm au contact de la couche mince.

Les calculs présentés ici se placent dans le cadre d'une structure comprenant un film élastique sur une fondation visqueuse/liquide. La fondation est rendue liquide par fusion de sa phase solide à l'aide d'un apport d'énergie focalisé, typiquement laser (UV 308nm, pulse de 150 ns, énergie de 0,8 J.cm-2). La fondation en silicium absorbe la majorité de l'apport d'énergie fourni, la

peau en $SiO_2$ reste transparente à la longueur d'onde de travail.

| Couche mince | | |
|---|---|---|
| Module d'Young | Ep | 80 GPa |
| Poisson | Np | 0.17 |
| Contrainte initiale | Cp | 200 MPa |
| Fondation liquide | | |
| Module d'Young | Ef | 120 GPa |
| Module de relaxation | $\mu$f | 50 MPa |
| Poisson | Np | 0.22 |

## Période des rides

Lorsque les conditions thermodynamiques sont compatibles avec la formation de rides, la période d'oscillation la plus favorable au système est atteinte instantanément. Dans le cadre de l'invention, la période est alors fixée au cours du refroidissement, pendant lequel on considère que la fondation est dans un état visqueux. La période des rides $\lambda$ est définie par la formule ci-dessous, d'après la publication de R. Huang intitulée « Kinetic wrinkling of an elastic film on a viscoelastic substrate », Journal of Mechanics and Physics of Solids, 2004.

$$\lambda = 2\pi\,h\left[\frac{(1-\upsilon_f)}{6(1-\upsilon_p^2)}\frac{E_p}{\mu_f}\right]^{1/3}$$

Le caractère instantané de l'instauration de la période implique que celle-ci va évoluer dans le temps si les paramètres qui la définissent évoluent, notamment $\mu$f, module de relaxation visqueux de la fondation. $\mu$f est défini par la formule suivante :

$$\mu_f = \frac{E_f}{2(1+\nu_f)}$$

Dans le système dynamique étudié, où la fondation passe de sa phase solide à liquide puis de nouveau solide, la fondation voit son module de relaxation évoluer dramatiquement. D'après Huang 2004, on peut estimer que $\mu$f varie sur plus de cinq ordres de grandeur, c'est-à-dire de $50.10^9$ Pa pour sa phase solide à quelques $50.10^4$ Pa pour sa phase visqueuse/liquide. La période $\lambda$ évolue en conséquence pour se figer lors du retour à la phase solide de la fondation autour d'une valeur correspondant à une "valeur moyenne" de $\mu$f estimée à $50.10^6$ Pa. Ainsi, dans ce cas, la période d'oscillation calculée est $\lambda = 1.879\mu$m ce qui correspond à ce qui est observé.

## Amplitude des rides

La croissance de l'amplitude des rides est un phénomène cinétique. Il est d'autant plus rapide que la fondation est dans son état liquide. Ainsi, dans l'exemple étudié où le temps de fusion est de l'ordre 500 ns l'amplitude des oscillations peut atteindre sa valeur maximale décrite dans le cas d'un système peau élastique/fondation liquide.

On peut alors utiliser la formule suivante, d'après la publication de Cerda & Pociavesk, Science, "Stress and Fold Localization in Thin Elastic Membranes", 2008.

$$A = \frac{\sqrt{2}}{\pi}\,\lambda\,\sqrt{\frac{\Delta}{W}}\,,\,\text{avec}\,\Delta = \frac{|\sigma_p|.W}{E_p}$$

représentant la distance de contraction de la peau.

Dans le calcul de la distance $\Delta$, le module d'Young de la peau intervient. Bien que l'on soit dans un cas où l'application de l'énergie est rapide (pulse de 150ns) et que le procédé complet dure moins de 1$\mu$s, il est raisonnable de considérer ici que lorsque la fondation est liquide le module d'Young estimée de la peau baisse d'un ordre de grandeur, de $80.10^9$ Pa à $8.10^9$ Pa. On calcule alors une amplitude A de 134 nm soit une hauteur crête à crête de 268 nm.

La figure 3 illustre à ce propos la formation de rides de longueur d'onde d'environ 2 $\mu$m et d'amplitude crête à crête de 268 nm.

Cette amplitude crête à crête correspond ainsi à une amplitude crête à crête théorique des rides qui peut être prédéterminée, et être utilisée pour définir l'épaisseur L de la fondation destinée à être fusionnée en sa phase liquide.

Ainsi, dans le cadre de l'exemple des figures 2a-2d où la fondation prend la forme d'un substrat 3, lorsque l'épaisseur L fusionnée est inférieure à une épaisseur prédéterminée correspondant à l'amplitude crête à crête théorique des rides, les rides formées présentent alors une amplitude crête à crête inférieure à l'amplitude crête à crête théorique. Le contrôle de l'épaisseur fusionnée permet ainsi de contrôler l'amplitude des rides formées.

Dans le cadre de l'invention, la fondation prend la forme d'une couche 30 reposant sur un substrat 40, et l'épaisseur H de la couche 30 est inférieure à l'épaisseur prédéterminée correspondant à l'amplitude crête à crête théorique des rides. La formation des rides s'accompagne alors comme représenté sur les figures 4b et 4c d'un contact localisé entre la couche mince 21 et le substrat rigide 40 isolant des régions de la fondation 320 entre des zones de contact localisé C1 de la couche 21 et du substrat 40. Là où la théorie prédit une amplitude crête à crête théorique d'environ 268 nm, à partir d'une couche mince en $SiO_2$ de 50 nm d'épaisseur et de contrainte initiale en tension d'environ 200 MPa et d'une fondation-couche de 150 nm d'épaisseur, il a été observé une amplitude crête à crête limitée à 230 nm.

Ce contact est transformé en adhésion lorsque les surfaces de la couche mince et du substrat sont lisses, par exemple avec une rugosité de surface inférieure à 5 nm RMS, ou encore un réalisant un apport d'énergie thermique complémentaire de renforcement de l'adhésion, ou encore via la réitération de l'étape de fusion.

Dans le cadre de l'invention, le procédé comprend, à l'issue d'un cycle fusion/solidification, une étape de retrait de la fondation ramenée à l'état solide pour suspendre la couche élastique 21 au-dessus du substrat en dehors des zones de contact adhérent localisé C1.

Le ou les matériaux composant le substrat 40, la fondation 30 et la couche élastique 20 peuvent en particulier être choisis de telle manière que la fondation 30 présente par rapport à la couche élastique 20 et au substrat 40 une forte sélectivité vis-à-vis d'une gravure, typiquement une sélectivité supérieure à 1000/1. Le procédé selon l'invention comporte alors une étape de gravure du matériau solide 320 de fondation reposant sous la couche mince 21 pour former une structure constituée du substrat 40 et de la couche mince suspendue au-dessus du substrat en dehors des zones de contact adhérent localisées. Une telle structure s'avère intéressante notamment lorsque qu'une déformation d'une telle couche suspendue s'accompagne d'un phénomène physique tel par exemple qu'un effet piézoélectrique. La gravure de la fondation nécessite de dégager un accès vers la fondation. Cet accès est typiquement réalisé en venant positionner un masque de gravure et réaliser une gravure de la couche mince non protégée par le masque pour pratiquer une ouverture, par exemple sous la forme d'une tranchée, vers le matériau de la fondation. L'agencement des rides peut dans certains cas faciliter cette étape de gravure. Ainsi, lorsque celles-ci sont agencées au moins localement sous forme de lignes parallèles, on peut choisir de de réaliser au moins une tranchée perpendiculaire aux rides pour faciliter l'accès de la solution de gravure. La gravure de la fondation est ensuite réalisée qui conduit à une pénétration de l'agent de gravure le long des rides en dessous de la couche mince.

On relèvera que le procédé peut comprendre avant retrait de la fondation, un retrait de la couche élastique (par exemple par gravure sélective vis-à-vis de la fondation et du substrat) puis un dépôt d'une nouvelle couche sur la fondation et le substrat. Cette nouvelle couche prend également la forme d'une couche ondulée conformément aux rides et en contact adhérent localisé avec le substrat. Cette nouvelle couche ondulée formera la couche localement suspendue après retrait de la fondation.

En variante, une ou plusieurs couches peuvent être déposées sur la couche ondulée, avant ou après retrait de la fondation.

D'une manière générale, la couche ondulée (couche mince, ou nouvelle couche déposée) peut être une structure multi-couches, par exemple une structure comprenant une couche en matériau piézoélectrique prise en sandwich entre deux couches métalliques. Et après retrait de la fondation, la couche ondulée reposant localement sur le substrat peut être recouverte d'une ou plusieurs couches, par exemple d'encapsulation.

Orientation des rides

S'agissant de l'orientation O des rides, une orientation privilégiée de structuration peut être définie en disposant d'une couche élastique dont la contrainte présente initialement une rupture de continuité dans le plan de la couche, de préférence des ruptures de contrainte dans une seule direction du plan espacées d'une longueur inférieure à 2000 fois l'épaisseur h de la couche. On a représenté sur la figure 5a un bas-relief introduisant de telles ruptures de contrainte, ici espacées de 100 $\mu$m, avec une couche-fondation 30 présentant une épaisseur de 150 nm au niveau du bas-relief et de 70 nm ailleurs. La figure 5b illustre la formation de rides orientées de manière quasi-parallèle à partir d'une couche mince contrainte 20 en $SiO_2$ de 50 nm d'épaisseur et présentant une contrainte initiale en tension de 100 MPa, d'une couche-fondation 30 en Si présentant le bas-relief de la figure 5a et reposant sur un substrat 40 de Si comportant en surface une couche intermédiaire thermiquement isolante en $SiO_2$.

Dans un mode de réalisation, le procédé peut comprendre une étape initiale de création de motifs en surface de la couche élastique et/ou de la fondation pour induire ladite rupture de continuité de contrainte. Cette création de motifs est par exemple réalisée au moyen d'un trait de laser.

Dans un exemple d'application possible, la couche mince et la fondation peuvent être choisies de manière à présenter une sélectivité vis-à-vis d'une gravure, par exemple une gravure sèche humide ce qui permet de réaliser un retrait de la peau ou de la fondation. Dans la mesure où, à l'issue de l'étape de solidification, la structure formée 10', 100' reste figée, un tel retrait ne conduit pas à la disparition de la structuration de surface ridée.

Dans un exemple d'application ne faisant pas partie de l'invention, lorsque la fondation prend la forme d'une couche 30 reposant sur un substrat rigide 40, la fondation et le substrat peuvent être choisis de manière à présenter une sélectivité faible, de préférence une sélectivité nulle, vis-à-vis d'une gravure, par exemple une gravure sèche humide. De telle manière, après éventuel retrait de la couche mince lorsqu'elle ne présente pas elle aussi une sélectivité faible vis-à-vis de la gravure retenue, la structuration de surface est transférée de la fondation au substrat.

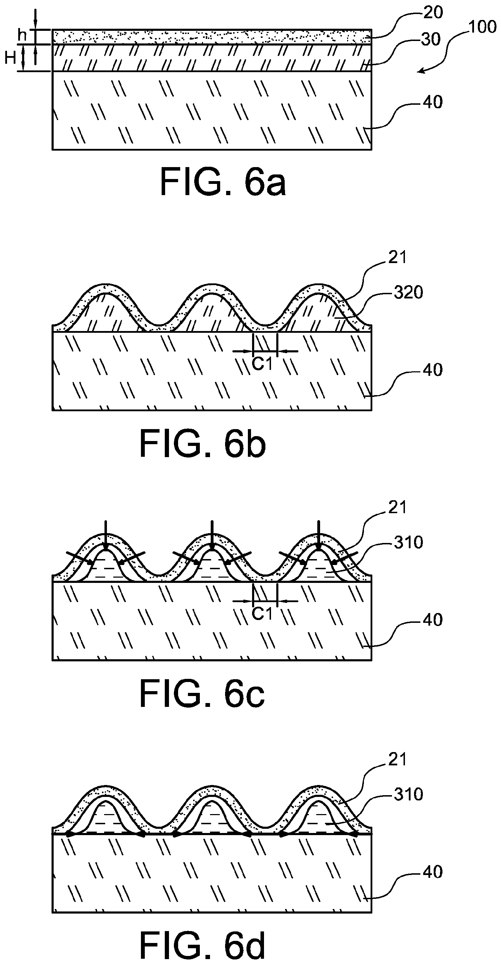

Une variante du procédé selon l'invention où la fondation prend la forme d'une couche 30 reposant sur un substrat 40 dont l'épaisseur fusionnée H est inférieure à l'épaisseur prédéterminée correspondant à l'amplitude crête à crête théorique des rides, est détaillée ci-après en référence aux figures 6a-6e.

La figure 6a représente la structure initiale 100 constituée du substrat 40, de la fondation 30 et de la couche mince élastique contrainte 20. La figure 6b représente la structure obtenue suite aux étapes de fusion et de solidification décrites précédemment permettant d'aboutir à la formation de rides figées et à un contact adhérent localisé de la couche mince ridée 21 avec le substrat 40 isolant des régions de la fondation solide ridée. Une zone de contact adhérent localisé entre la couche mince et le substrat forme un intervalle séparant deux régions adjacentes de la fondation qui s'étend sur une distance C1.

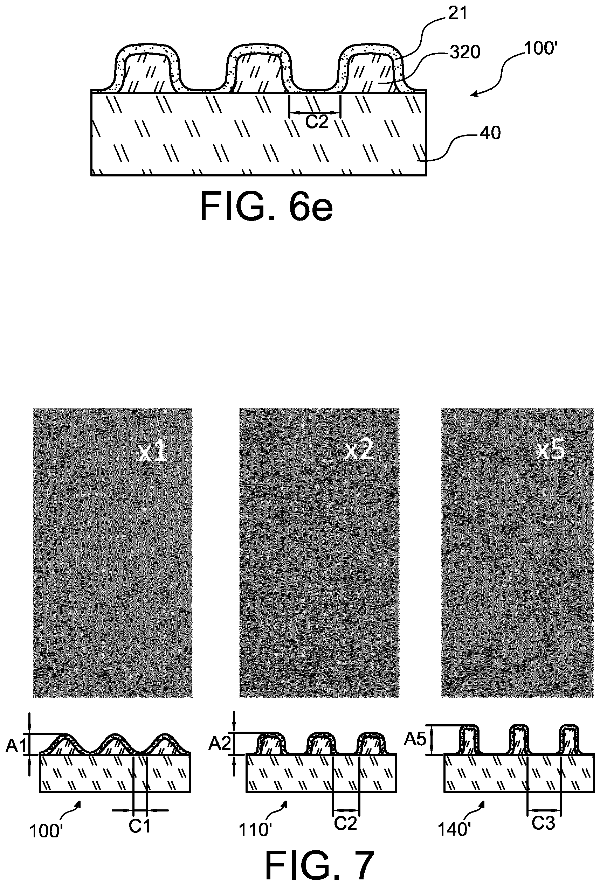

Dans le cadre de cette variante, on peut venir réitérer les étapes de fusion et de solidification. En prenant l'exemple d'une fondation en un matériau qui présente la propriété de se contracter volumiquement lors du passage de son état solide à son état liquide (comme c'est le cas par exemple des matériaux suivants : Si, Ga, Ge, Pu, Sb, $\alpha$-ZrW$_2$O$_8$, C$_2$N$_2$Zn, H$_2$O), on vient dans le cadre de cette variante réitérer les étapes de fusion et de solidification de sorte que le moindre volume en phase liquide de la fondation 310, illustré sur la figure 6c, s'accompagne d'un contact adhérent de la couche mince 21 avec le substrat 40 sur une distance plus importante ce qui favorise l'adhésion comme représenté sur la figure 6d. Il en résulte, après solidification, la structure 110' représentée sur la figure 6e pour laquelle l'intervalle C2 entre les régions isolées de la fondation est accentué et l'amplitude des rides est augmentée.

Comme représenté sur la figure 7, il est possible de réitérer à de multiples reprises les étapes de fusion et de solidification, tant que la couche mince résiste à la déformation. Les travaux d'adhésion de la couche mince et du substrat affinent les régions isolées de fondation dans les structures formées 100', 110', 140' (après respectivement 1, 2 et 5 séquences fusion/solidification de gauche à droite sur la figure 7) qui voient leur amplitude A1, A2, A5 progressivement augmenter tandis que l'intervalle C1, C2, C5 séparant les régions isolées augmente. Les régions isolées présentent l'avantage d'être lisses car issues d'une phase liquide et présentent ainsi moins de défauts par comparaison à des procédés lithographiques suivis de gravure. La réitération de l'étape de fusion permet en outre de renforcer l'adhésion des zones de contact adhérent localisé C1, C2, C5 avec le substrat.

On veille dans le cadre de cette variante de l'invention à limiter le nombre de réitérations des étapes de fusion et de solidification afin que la couche mince résiste aux contraintes de déformation. Et on peut procéder au retrait de la fondation suite à plusieurs réitérations du des étapes de fusion et de solidification.

En effet, la déformation de la peau présentant une limite, lors d'une réitération de l'étape de fusion, le liquide se trouve encore plus confiné et le retour à l'état solide conduit à une élévation trop importante de la pression. Ceci entraîne la rupture de la couche mince dans la zone où le stress est maximal, à savoir au maximum d'amplitude des rides. Cette rupture s'accompagne de l'éruption du liquide en fusion issue de la fondation. Ce liquide peut se déverser le long de la peau. Si les conditions sont propices, et notamment si le matériau en fusion présente une faible mouillabilité vis-à-vis du matériau de surface de la peau (correspondant typiquement à un angle de goutte supérieur à 80°), une bille nanométrique de matériau peut se former au sommet du cratère.

## Revendications

1. Procédé de formation d'une couche ondulée (21) reposant localement sur un substrat à partir d'une structure (100) comprenant une couche élastique contrainte (20) sur une fondation (30) à l'état solide présente en surface d'un substrat rigide (40), le procédé comprenant la mise en œuvre des étapes de :

   - fusion de la fondation (310) pour l'amener à l'état liquide pendant une durée supérieure ou égale à 50 ns, l'épaisseur (H) de la fondation étant d'au moins 20 nm et inférieure à une épaisseur prédéterminée correspondant à une amplitude crête à crête théorique de rides, ladite fusion résultant en une relaxation de contrainte de la couche élastique qui engendre une déformation simultanée, par formation de rides, de la couche élastique (21) et de la fondation (310), la formation des rides isolant des régions de la fondation (320) entre des zones de contact adhérent localisé (C1, C2, C5) entre la couche élastique (21) et le substrat rigide (40) ;
   - solidification de la fondation pour la ramener à l'état solide (320), ladite solidification formant une structure solide (100') présentant des rides en surface ;

   le procédé étant **caractérisé en ce qu'**il comprend une étape de retrait de la fondation ramenée à l'état solide (320) pour suspendre une couche (21) au-dessus du substrat en dehors des zones de contact adhérent localisé (C1, C2, C5), la couche suspendue étant ondulée conformément aux rides en surface de la structure solide (100').

2. Procédé selon la revendication 1, dans lequel la fusion est réalisée au moyen d'un apport d'énergie sélectif selon lequel l'énergie est absorbée par ladite partie au moins de la fondation plutôt que par la couche élastique contrainte avec un ratio de 100/1, de préférence avec un ratio de 1000/1.

3. Procédé selon l'une des revendications 1 et 2, dans lequel la durée de chacune des étapes de fusion et de solidification est inférieure à 1 seconde, de préférence inférieure à 1 microseconde.

4. Procédé selon l'une des revendications 1 à 3, dans lequel une couche thermiquement isolante (50) est intercalée entre la fondation et le substrat rigide.

**5.** Procédé selon l'une des revendications 1 à 4, dans lequel, la fondation (30) étant conductrice électriquement et intercalée entre des matériaux électriquement isolant, la fusion de ladite au moins une partie de la fondation est réalisée par un apport d'énergie thermique exploitant l'effet joule.

**6.** Procédé selon l'une des revendications 1 à 4, dans lequel, la fondation (30) étant intercalée entre des matériaux électriquement conducteurs et présentant une résistivité supérieure à celle desdits matériaux électriquement conducteurs, la fusion de ladite au moins une partie de la fondation est réalisée par un apport d'énergie thermique exploitant un échauffement résistif.

**7.** Procédé selon l'une des revendications 1 à 6, dans lequel les étapes de fusion et de solidification sont réitérées avant l'étape de retrait de la fondation ramenée à l'état solide, de manière à augmenter l'amplitude des rides et l'intervalle (C1, C2, C5) entre les régions isolées de la fondation (320) sans atteindre la limite de rupture de la couche élastique (21).

**8.** Procédé selon l'une des revendications 1 à 7, dans lequel le retrait de la fondation ramenée à l'état solide est réalisé par gravure sélective de la fondation (320) vis-à-vis du substrat rigide et vis-à-vis d'une couche (21) reposant localement sur le substrat rigide (40).

**9.** Procédé selon l'une des revendications 1 à 8, dans lequel la couche suspendue est formée par la couche élastique (21).

**10.** Procédé selon l'une des revendications 1 à 8, comprenant avant retrait de la fondation, une étape de retrait de la couche élastique (21) suivie d'une étape de dépôt d'une nouvelle couche en surface du substrat et de la fondation, ladite nouvelle couche formant à l'issue du retrait de la fondation la couche suspendue.

**11.** Procédé selon l'une des revendications 1 à 10, dans lequel la couche élastique dispose initialement d'une contrainte présentant une rupture de continuité dans le plan de la couche.

**12.** Procédé selon la revendication 11, comprenant une étape de création de motifs en surface de la couche élastique et/ou de la fondation pour induire ladite rupture de continuité.

## Patentansprüche

**1.** Verfahren zum Bilden einer gewellten Schicht (21), die bereichsweise auf einem Substrat aufliegt, ausgehend von einer Struktur (100), die eine beanspruchte elastische Schicht (20) auf einem Untergrund (30) im festen Zustand enthält, der an der Oberfläche eines starren Substrats (40) vorhanden ist, wobei das Verfahren die Ausführung der folgenden Schritte umfasst:

- Schmelzen des Untergrunds (310), um ihn für eine Zeitdauer von mehr als oder gleich 50 ns in den flüssigen Zustand zu bringen, wobei die Dicke (H) des Untergrunds mindestens 20 nm und weniger als eine vorbestimmte Dicke beträgt, die einer theoretischen Spitze-Spitze-Amplitude von Falten entspricht, wobei das Schmelzen zu einer Spannungsrelaxation der elastischen Schicht führt, die eine gleichzeitige Verformung der elastischen Schicht (21) und des Untergrunds (310) durch Faltenbildung bewirkt, wobei mit Bildung der Falten Bereiche des Untergrunds (320) zwischen Zonen eines bereichsweisen Haftkontakts (C1, C2, C5) zwischen der elastischen Schicht (21) und dem starren Substrat (40) getrennt werden;
- Verfestigen des Untergrunds, um ihn in den festen Zustand zurückzubringen (320), wobei das Verfestigen eine feste Struktur (100') mit Oberflächenfalten bildet;

wobei das Verfahren **dadurch gekennzeichnet ist, dass** es einen Schritt des Entfernens des in den festen Zustand zurückgebrachten Untergrunds (320) umfasst, um eine Schicht (21) über dem Substrat außerhalb der Zonen des bereichsweisen Haftkontakts (C1, C2, C5) abzuhängen, wobei die abgehängte Schicht entsprechend den Oberflächenfalten der festen Struktur (100') gewellt ist.

**2.** Verfahren nach Anspruch 1, wobei das Schmelzen mittels selektiver Energiezufuhr durchgeführt wird, wobei die Energie vielmehr von dem mindestens einen Teil des Untergrunds als von der beanspruchten elastischen Schicht in einem Verhältnis von 100:1, vorzugsweise in einem Verhältnis von 1000:1, absorbiert wird.

**3.** Verfahren nach einem der Ansprüche 1 und 2, wobei die Dauer jedes der Schritte des Schmelzens und Verfestigens weniger als 1 Sekunde, vorzugsweise weniger als 1 Mikrosekunde, beträgt.

**4.** Verfahren nach einem der Ansprüche 1 bis 3, wobei eine wärmeisolierende Schicht (50) zwischen dem Untergrund und dem starren Substrat eingefügt wird.

**5.** Verfahren nach einem der Ansprüche 1 bis 4, wobei bei einem elektrisch leitenden und zwischen elektrisch isolierenden Materialien eingefügten Untergrund (30) das Schmelzen des zumindest einen Teils des Untergrunds durch Zufuhr von Wärmeenergie unter Ausnutzung des Joule-Effekts erfolgt.

**6.** Verfahren nach einem der Ansprüche 1 bis 4, wobei bei einem Untergrund (30), der zwischen elektrisch leitenden Materialien eingefügt ist und einen spezifischen Widerstand aufweist, der größer ist als der der elektrisch leitenden Materialien, das Schmelzen des zumindest einen Teils des Untergrunds durch Zufuhr von Wärmeenergie unter Ausnutzung einer Widerstandserwärmung erfolgt.

**7.** Verfahren nach einem der Ansprüche 1 bis 6, wobei die Schritte des Schmelzens und des Verfestigens wiederholt werden, bevor der Schritt des Entfernens des in den festen Zustand zurückgebrachten Untergrunds erfolgt, um die Amplitude der Falten und den Spalt (C1, C2, C5) zwischen den getrennten Bereichen des Untergrunds (320) zu vergrößern, ohne die Bruchgrenze der elastischen Schicht (21) zu erreichen.

**8.** Verfahren nach einem der Ansprüche 1 bis 7, wobei das Entfernen des in den festen Zustand zurückgebrachten Untergrunds durch selektives Ätzen des Untergrunds (320) in Bezug auf das starre Substrat und in Bezug auf eine bereichsweise auf dem starren Substrat (40) aufliegende Schicht (21) erfolgt.

**9.** Verfahren nach einem der Ansprüche 1 bis 8, wobei die abgehängte Schicht aus der elastischen Schicht (21) gebildet wird.

**10.** Verfahren nach einem der Ansprüche 1 bis 8, umfassend vor dem Entfernen des Untergrunds einen Schritt des Entfernens der elastischen Schicht (21), gefolgt von einem Schritt des Abscheidens einer neuen Schicht auf der Oberfläche des Substrats und des Untergrunds, wobei die neue Schicht nach dem Entfernen des Untergrunds die abgehängte Schicht bildet.

**11.** Verfahren nach einem der Ansprüche 1 bis 10, wobei die elastische Schicht anfänglich eine Spannung aufweist, die einen Kontinuitätsbruch in der Ebene der Schicht zeigt.

**12.** Verfahren nach Anspruch 11, umfassend einen Schritt des Erzeugens von Oberflächenmustern auf der elastischen Schicht und/oder dem Untergrund, um den Kontinuitätsbruch herbeizuführen.

**Claims**

**1.** A method for forming an undulated layer (21) locally lying on a substrate from a structure (100) comprising a strained elastic layer (20) on a foundation (30) in the solid state present at the surface of a rigid substrate (40), the method comprising the steps of:

- melting the foundation (310) to bring it to the liquid state for a duration higher than or equal to 50ns, the thickness (H) of the foundation being at least 20nm and lower than a predetermined thickness corresponding to a theoretical peak-to-peak amplitude of wrinkles, said melting resulting in a stress relaxation of the elastic layer which generates a simultaneous deformation, by formation of wrinkles, of the elastic layer (21) and of the foundation (310), the formation of the wrinkles separating regions of the foundation (320) between zones of localized adherent contact (C1, C2, C5) between the elastic layer (21) and the rigid substrate (40);
- solidifying the foundation to bring it back to the solid state (320), said solidification forming a solid structure (100') having wrinkles at the surface;

the method being **characterized in that** it comprises a step of removing the foundation brought back to the solid state (320) to suspend a layer (21) above the substrate outside of the zones of localized adherent contact (C1, C2, C5), the suspended layer being undulated in accordance with the wrinkles at the surface of the solid structure (100').

**2.** The method according to claim 1, wherein the melting is made by means of a selective energy supply by which the energy is absorbed by said at least part of the foundation rather than by the strained elastic layer with a ratio of 100/1, preferably with a ratio of 1000/1.

**3.** The method according to one of claims 1 and 2, wherein the duration of each of the melting and solidification steps is lower than 1 second, preferably lower than 1 microsecond.

**4.** The method according to one of claims 1 to 3, wherein a thermally insulating layer (50) is inserted between the foundation and the rigid substrate.

**5.** The method according to one of claims 1 to 4, wherein, the foundation (30) being electrically conducting and inserted between electrically insulating materials, the melting of said at least one part of the foundation is made by a thermal energy supply making use of the joule effect.

**6.** The method according to one of claims 1 to 4, wherein, the foundation (30) being inserted between electrically insulating materials and having a resistivity higher than that of said electrically conducting materials, the melting of said at least one part of the foundation is made by a thermal energy supply making use of a resistive heating.

7. The method according to one of claims 1 to 6, wherein the melting and solidification steps are reiterated before the step of removing the foundation brought back to the solid state, so as to increase the amplitude of the wrinkles and the interval (C1, C2, C5) between the separated regions of the foundation (320) without reaching the yield point of the elastic layer (21).

8. The method according to one of claims 1 to 7, wherein the removal of the foundation brought back to the solid state is made by a selective etching of the foundation (320) with respect to the rigid substrate and with respect to a layer (21) locally lying on the rigid substrate (40).

9. The method according to one of clams 1 to 8, wherein the suspended layer is formed by the elastic layer (21).

10. The method according to one of claims 1 to 8, comprising before removing the foundation, a step of removing the elastic layer (21) followed by a step of depositing a new layer at the surface of the substrate and of the foundation, said new layer forming at the end of the removal of the foundation, the suspended layer.

11. The method according to one of claims 1 to 10, wherein the elastic layer initially has a stress having a discontinuity in the plane of the layer.

12. The method according to claim 11, comprising a step of creating patterns at the surface of the elastic layer and/or of the foundation to induce said discontinuity.

FIG. 1a

FIG. 1b

FIG. 1c

FIG. 2a

FIG. 2b

FIG. 2c

FIG. 2d

FIG. 3

FIG. 4a

FIG. 4b

FIG. 4c

FIG. 5a

FIG. 5b

FIG. 6a

FIG. 6b

FIG. 6c

FIG. 6d

FIG. 6e

FIG. 7

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **G.K. GIUST ; T.W. SIGMON.** New ripple patterns observed in excimer-laser irradiated SiO2/polycrystalline silicon/SiO2 structures. *Appl. Phys. Lett.,* 1997, vol. 70, 3552

- **R. HUANG.** Kinetic wrinkling of an elastic film on a viscoelastic substrate. *Journal of Mechanics and Physics of Solids,* 2004
- **CERDA ; POCIAVESK.** Stress and Fold Localization in Thin Elastic Membranes. *Science,* 2008